## Europäisches Patentamt
## European Patent Office
## Office européen des brevets

(19)

(11) Veröffentlichungsnummer: **0 055 795**
**B1**

(12) **EUROPÄISCHE PATENTSCHRIFT**

(45) Veröffentlichungstag der Patentschrift:
**18.12.85**

(51) Int. Cl.⁴: **H 03 K 5/02**

(21) Anmeldenummer: 81107047.3

(22) Anmeldetag: 08.09.81

(54) Schnelle MOS-Treiberschaltung für Digitalsignale.

(30) Priorität: **20.12.80 EP 80108079**

(43) Veröffentlichungstag der Anmeldung:
**14.07.82 Patentblatt 82/28**

(45) Bekanntmachung des Hinweises auf die Patenterteilung:
**18.12.85 Patentblatt 85/51**

(84) Benannte Vertragsstaaten:
**DE FR GB IT NL**

(56) Entgegenhaltungen:
DE - B - 1 487 398
DE - B - 2 623 507
DE - B - 2 649 356
US - A - 4 101 788

NACHRICHTENTECHNIK-ELEKTRONIK, Band 25, Nr. 3, 1975, F. RÜSSLER "Gesichtspunkte für den Entwurf integrierter MIS-Schaltungen", Seiten 94 bis 99

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Gollinger, Wolfgang, Dipl.-Ing., Reinhold-Schneider-Strasse 18a, D-7803 Gundelfingen (DE)**
Erfinder: **Mlynek, Daniel, Dr.-Ing., 7, Rue de Jardin, F-68600 Wolfgantzen (FR)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

## Beschreibung

Die Erfindung bezieht sich auf eine monolithisch mittels Isolierschicht-Feldeffekttransistoren integrierte, schnelle Treiberschaltung für Digitalsignale, die zwischen eine Lastkapazität und den Ausgang einer nur mit der demgegenüber kleinen Eingangskapazität der Treiberschaltung belastbaren Stufe geschaltet ist entsprechend dem Oberbegriff von Anspruch 1. Derartige MOS-Treiberschaltungen für Digitalsignale sind in der Auslegeschrift DE-B2-2 623 507 beschrieben.

Die Erfindung, wie sie in den Ansprüchen gekennzeichnet ist, löst für grössere Kapazitätsverhältnisse als etwa 15 bis 30 bei Realisierung in Zweiphasen-Ratiotechnik die Aufgabe, eine schnelle MOS-Treiberschaltung für Digitalsignale anzugeben, die für in der Praxis vorkommende Kapazitätsverhältnisse mit weniger Gesamtstrom als die vorbeschriebene Anordnung bei gleichem dynamischem Verhalten auskommt und ausserdem einen grösseren Störabstand aufweist. Dabei wird auf das an sich bekannte Prinzip nach der Auslegeschrift DE-B2-1 487 398 zurückgegriffen. Dieses besteht darin, dass die zur Realisierung des Kapazitätsverhältnisses von Lastkapazität zu Eingangskapazität signalflussmässig in Reihe geschalteten Inverter vorgesehen sind, deren Schalttransistoren Kanalbreiten aufweisen, die in Richtung des Signalflusses mindestens teilweise von Stufe zu Stufe nach einer geometrischen Reihe zunehmen.

Diese MOS-Treiberschaltungen haben zwar die Eigenschaft, je nach Stufenzahl auch sehr grosse Kapazitätsverhältnisse mit kurzen Schaltzeiten zu beherrschen, jedoch haben sie den Nachteil, dass mit grösser werdender Stufenzahl auch der in der Treiberschaltung fliessende Gesamtstrom mit dem Multiplikationsfaktor der geometrischen Reihe zunimmt, da in einer derartigen signalflussmässigen Reihenschaltung von Invertern immer etwa die Hälfte der Inverter stromdurchflossen ist, was bei vorausgesetzter positiver Logik dem niederen Binärpegel L am Ausgang dieser Inverter entspricht.

Aus der Zeitschrift «Nachrichtentechnik-Elektronik», 1975, Seiten 94 bis 99, insbesondere Bild 10 mit Beschreibung, ist es bekannt, dem Eingang eines Inverters einen an seinem Gate von einem Taktsignal gesteuerten Transfertransistor vorzuschalten, wodurch der Inverter Flip-Flopverhalten annimmt. Diese Wirkung liegt jedoch bei der entsprechenden Teilschaltung der Erfindung nicht vor und ist auch nicht beabsichtigt. Vielmehr soll die temporäre Speicherfähigkeit am Steuergate des Inverters so ausgenutzt werden, dass die Anpassung der Eingangskapazität an die Lastkapazität während einer Taktsignalperiode möglich ist, und zwar so aufgeteilt, dass in der einen Halbperiode der dem einen Kapazitätsverhältnis-Teil zugeordnete Schaltungsteil und in der anderen der andere wirksam wird. Dadurch wird nämlich das oben erwähnte dynamische Verhalten günstig beeinflusst.

Die durch die Erfindung erreichten Vorteile ergeben sich unmittelbar aus der Lösung der gestellten Aufgabe. Weitere Vorteile sind in der nun folgenden Erfindungsbeschreibung angegeben, die sich auf die Figuren der Zeichnung bezieht.

Fig. 1 zeigt das Schaltbild der bekannten MOS-Treiberschaltung,

Fig. 2 zeigt das Schaltbild des Ausgangsteils einer MOS-Treiberschaltung nach der Erfindung,

Fig. 3 zeigt das vollständige Schaltbild einer MOS-Treiberschaltung nach der Erfindung,

Fig. 4 zeigt den zeitlichen Verlauf der bei der Erfindung verwendeten Zweiphasen-Taktsignale, und

Fig. 5 zeigt ein dimensioniertes Ausführungsbeispiel entsprechend Fig. 3.

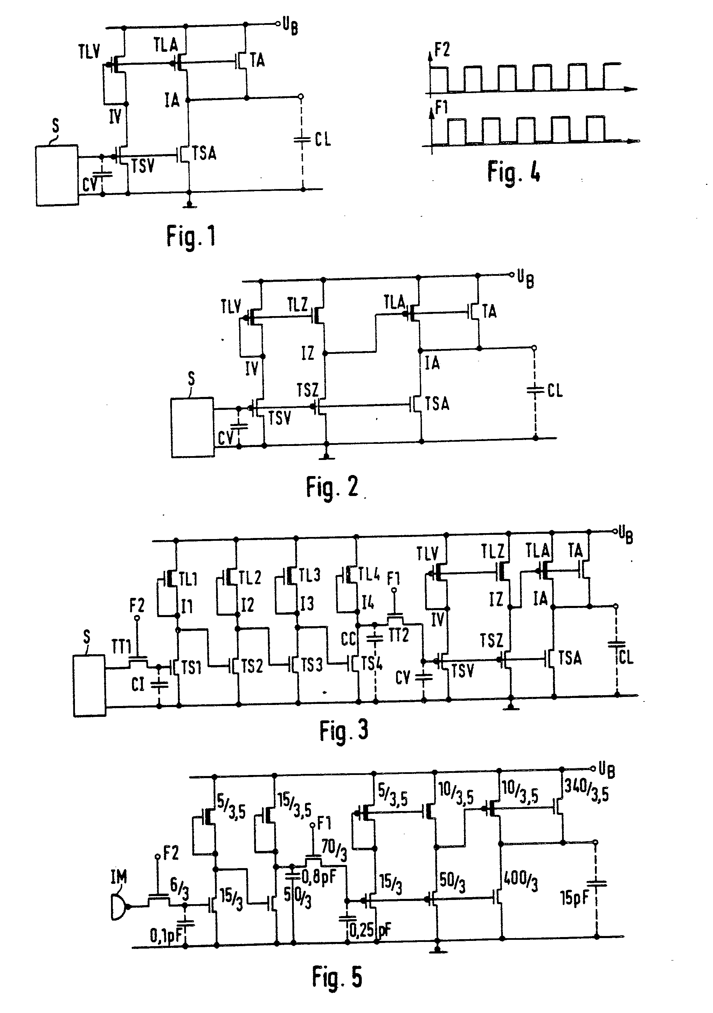

In Fig. 1 ist das Schaltbild der bekannten Anordnung nach der Auslegeschrift DE-B2-2 623 507 gezeigt. Die Stufe S soll mit ihrem Ausgang eigentlich auf die rechts in Fig. 1 gestrichelt gezeichnete Lastkapazität CL arbeiten, die beispielsweise aus der Eingangskapazität einer nachfolgenden Stufe der integrierten Gesamtschaltung bestehen kann, von der die MOS-Treiberschaltung der Erfindung ein Teil sein kann. Die Lastkapazität CL kann aber auch die Kapazität einer von aussen an die integrierte Schaltung anzuschliessenden weiteren Schaltung sein. Jedenfalls ist der Wert der Kapazität CL grösser als die Kapazität, die vom Ausgang der Stufe S bei möglichst schneller Signaldurchschaltung noch auf- und entladen werden kann. Diese wesentlich kleinere Kapazität entspricht der Eingangskapazität der MOS-Treiberschaltung der Erfindung, die somit zwischen den Ausgang der Stufe und die Lastkapazität CL geschaltet ist.

Die Schaltung nach Fig. 1 besteht aus dem Ausgangsinverter IA mit dem Schalttransistor TSA und dem Lasttransistor TLA, aus dem Vorinverter IV mit dem Schalttransistor TSV und dem Lasttransistor TLV sowie dem Anreicherungstransistor TA. Diese Transistoren sind wie folgt untereinander verschaltet: Die Gates der beiden Schalttransistoren TSV, TSA sind miteinander verbunden und liegen am Ausgang der Stufe S, die in der Lage ist, auf die Eingangskapazität CV der MOS-Treiberschaltung zu arbeiten, die sich im wesentlichen aus der Summe der Eingangskapazitäten der beiden Schalttransistoren TSV, TSA und der zugeordneten Verdrahtungskapazität zusammensetzt. Zu den beiden Schalttransistoren TSV, TSA sind die Lasttransistoren TLV, TLA als Lastelemente in Reihe geschaltet, die mit dem einen Ende ihrer Source-Drain-Strecke an der Betriebsspannung $U_B$ liegen, wobei die Source-Drain-Strecke des Anreicherungstransistors TA der des Lasttransistors TLA parallelgeschaltet ist. Die beiden Lasttransistoren TLV, TLA sind vom Verarmungstyp, während die Schalttransistoren TSV, TSA solche vom Anreicherungstyp sind. Die Gates der Lasttransistoren TLV, TLA und des Anreicherungstransistors TA sind am Ausgang des Vorinverters IV angeschlossen.

In Fig. 2 ist das Schaltbild des Ausgangsteils einer Treiberschaltung nach der Erfindung gezeigt. Zwischen dem Vorinverter IV und dem Ausgangsinverter IA ist der Zwischeninverter IZ derart eingefügt, dass das Gate von dessen Schalttransistor TSZ an den Gates der Schalttransistoren TSV, TSA und das Gate von dessen Lasttransistor TLZ am Ausgang des Vorinverters IV liegt und die Gates des Anreicherungstransistors TA und des Lasttransistors TLA des Ausgangsinverters IA mit dem Ausgang des Zwischeninverters IZ verbunden sind. Dabei ist der Zwischeninverter IZ wiederum ein Depletion-Load-Inverter, d.h. sein Lasttransistor TLZ ist vom Verarmungstyp und sein Schalttransistor TSZ vom Anreicherungstyp. Die Kanalbreite des Schalttransistors TSZ ist etwa um den Multiplikationsfaktor der geometrischen Reihe grösser als die des Schalttransistors TSV des Vorinverters IV. Das W/L Verhältnis (= Kanalbreite-Kanallänge-Verhältnis) des Anreicherungstransistors TA ist etwa gleich dem des Schalttransistors TSA. Durch die beschriebene Einfügung des Zwischeninverters IZ wird erreicht, dass der Lastkreis des Ausgangsinverters IA im Gegensatz zur bekannten Anordnung nach Fig. 1 dynamisch betrieben wird.

Die Anordnung nach Fig. 2 ist allerdings nur für zu beherrschende Kapazitätsverhältnisse C = CL/CV von etwa 15 bis 30 geeignet. Erst durch die Erfindung sind grössere Kapazitätsverhältnisse C beherrschbar, deren Grundgedanke darin besteht, das Kapazitätsverhältnis C so in zwei Faktoren C1, C2 zu zerlegen, dass der eine Teil mit der Anordnung nach Fig. 2, während der andere Teil nach dem in der oben genannten DE-B2-1 487 398 vorbeschriebenen Prinzip unter entsprechender, noch zu schildernder Modifizierung beherrscht werden kann.

Hierzu ist entsprechend dem Ausführungsbeispiel der Erfindung nach Fig. 3 bei Realisierung in der bekannten Zweiphasen-Ratiotechnik zwischen dem Ausgang der Stufe S und dem Eingang der MOS-Treiberschaltung mit der Eingangskapazität CI der erste Transfertransistor TT1 vorgesehen, der vom einen Zweiphasen-Taktsignal F2 gesteuert ist. In der bekannten Zweiphasen-Ratiotechnik sind die Inverter bezüglich des W/L-Verhältnisses von Schalt- und Lasttransistor so dimensioniert, dass die Schalttransistoren in einem bestimmten Verhältnis (= ratio) niederohmiger im eingeschalteten Zustand sind als die Lasttransistoren, so dass das Potential des Schaltungsnullpunkts als der niedere Pegel L der beiden Binärpegel möglichst gut erreicht wird.

Dem ersten Transfertransistor TT1 am Eingang der MOS-Treiberschaltung entspricht der zweite Transfertransistor TT2, der dem Eingang des nunmehr als Ausgangsstufe dienenden Schaltungsteils nach Fig. 2 vorgeschaltet ist und vom anderen Teil F1 des Zweiphasen-Taktsignals angesteuert ist, dessen zeitlicher Verlauf im übrigen in Fig. 4 gezeigt ist und aus zwei um 180° phasenverschobenen, sich nicht überlappenden Rechtecksignalen mit einem Impulsdauer-Impulspausen-Verhältnis von ca. 1 : 1 besteht.

Zwischen den beiden Transfertransistoren TT1, TT2 ist nun eine nach den Prinzipien der DE-B2-1 487 398 aufgebaute signalflussmässige Reihenschaltung der Vorstufen-Inverter I1, I2, I3, I4 angeordnet, deren Schalttransistoren TS1, TS2, TS3, TS4 vom Verarmungstyp sind, wobei das Gate jedes Lasttransistors mit dem Ausgang des entsprechenden Inverters verbunden ist, wodurch diese Verarmungstyp-Transistoren als nichtlineare Lastwiderstände geschaltet sind. Die W/L-Verhältnisse der Schalttransistoren TS1...TS4 nehmen entsprechend einer geometrischen Reihe von Inverter zu Inverter I1...I4 zu.

Dabei wird es im allgemeinen so sein, dass für den Kapazitätsverhältnis-Teil C2 = CV/CI eine Inverterzahl vorgesehen ist, die es eigentlich gestattet, ein grösseres Kapazitätsverhältnis zu beherrschen. Dies ist aber gerade günstig, denn dann wird der letzte Inverter I4 der Reihe durch die Eingangskapazität CV des nachfolgenden Schaltungsteils weniger als zulässig belastet, so dass dieser letzte Inverter einen demgegenüber schnelleren Spannungsanstieg erlaubt. Diese Spannungsanstiegsreserve kann dazu dienen, den durch die gegebenenfalls etwas langsamere nachfolgende Teilschaltung gegebenen Schnelligkeitsverlust zu kompensieren. Auf diese Weise kann die Stromaufnahme bei gleichbleibender Verzögerungszeit reduziert werden.

Wie aus Fig. 3 ersichtlich ist, wird mittels der beiden Transfertransistoren TT1, TT2 die Gesamtverzögerungszeit der MOS-Treiberschaltung auch so aufgeteilt, dass die Verzögerungszeit der Vorstufeninverter I1...I4 kürzer ist als die halbe Periodendauer des Zweiphasen-Taktsignals und die restliche Verzögerungszeit sozusagen in die andere Taktsignalhälfte passt.

Bezüglich der Vorstufen-Inverter I1...I4 ist nachzutragen, dass sie auf kürzeste Verzögerungszeit durch Konstanthalten des Quotienten aus der Eingangskapazität des innerhalb der Reihe nachfolgenden Inverters und dem W/L-Verhältnis des Lasttransistors des Inverters bemessen sind.

Eine vorteilhafte Weiterbildung besteht darin, dass das W/L-Verhältnis des Lasttransistors TLA des Ausgangsinverters Ia so bemessen ist, dass durch diesen Inverter etwa die Hälfte des Gesamtstroms der Treiberschaltung nach Fig. 3 fliesst.

Durch den gestrichelt eingezeichneten Kondensator CC ist eine Weiterbildung angedeutet, die ebenfalls zu einer Verringerung der Verlustleistung bei gleicher Schaltgeschwindigkeit führt und die darin besteht, dass vom Eingang des zweiten Transfertransistors TT2 der Kondensator CC zum Schaltungspunkt führt.

Schliesslich zeigt Fig. 5 ein bezüglich der W/L-Verhältnisse dimensioniertes Ausführungsbeispiel der Anordnung nach Fig. 3. Es ergibt sich bei Anwendung des Kondensators CC nach Fig. 3 eine Verlustleistung von 15 mW bei einer Zweiphasen-Taktsignal-Frequenz von 17 MHz. Dieses Ausführungsbeispiel ist für die Beherrschung eines Kapazitätsverhältnisses C = 150 ausgelegt. Der Kondensator CC hat einen Wert von 0,8 pF. Das grosse Kapazitätsverhältnis C bedingt eine entsprechend grosse Dimensionierung des W/L-Verhältnisses des Schalttransistors TSA des Ausgangsinverters IA und damit auch des Anreicherungstransistors TA, nämlich 400/3 bzw. 340/3,5.

Aus den angegebenen W/L-Verhältnissen ist ersichtlich, dass die dafür in den Ansprüchen angegebenen Bemessungsregeln eingehalten sind, vgl. beispielsweise die W/L-Verhältnisse des Schalttransistors des Ausgangsinverters und des Anreicherungstransistors, die etwa einander gleich sind, sowie die W/L-Verhältnisse des Lasttransistors des Ausgangsinverters und der Lasttransistoren der Vorstufen-Inverter.

Aus Fig. 5 ist schliesslich noch ersichtlich, dass auch die W/L-Verhältnisse der Transfertransistoren TT1, TT2 entsprechend dem mit den Vorstufen-Invertern beherrschbaren Kapazitätsverhältnis-Teil zu dimensionieren sind.

In den Fig. 1 bis 5 haben alle Transistoren dieselbe Leitungsart, sind also entweder P-Kanal- oder N-Kanal-Transistoren.

**Patentansprüche**

1. Monolithisch mittels Isolierschicht-Feldeffekttransistoren integrierte, schnelle Treiberschaltung für Digitalsignale, die zwischen eine Lastkapazität (CL) und den Ausgang einer nur mit der demgegenüber kleinen Eingangskapazität (CV; CI) der Treiberschaltung belastbaren Stufe (S; IM) geschaltet ist und zur Realisierung des Kapazitätsverhältnisses von Lastkapazität zu Eingangskapazität (C = CL/CV bzw. CL/CI) signalflussmässig in Reihe geschaltete Inverter, nämlich einen Ausgangsinverter (IA) und einen Vorinverter (IV) enthält, wobei ein mit seiner Source-Drain-Strecke der des Lasttransistors (TLA) des Ausgangsinverters (IA) parallelgeschalteter Anreicherungstransistor (TA) vorgesehen ist, dessen Gate zusammen mit den Gates der Lasttransistoren (TLV, TLA) der Inverter (IV, IA) am Ausgang des Vorinverters (IV) liegt, und die Gates der Schalttransistoren (TSV, TSA) der Inverter (IV, IA) miteinander verbunden sowie die Lasttransistoren (TLA, TLV) der Inverter (IA, IV) solche vom Verarmungstyp und die zugehörigen Schalttransistoren (TSA, TSV) solche vom Anreicherungstyp sind, gekennzeichnet durch folgende Merkmale für grössere Kapazitätsverhältnisse (C) als etwa 15 bis 30 bei Realisierung in Zweiphasen-Ratiotechnik:
– für einen Kapazitätsverhältnis-Teil (C1) von etwa 15 bis 30, wobei gilt C = C1 · C2,
– nehmen die Kanalbreiten der Schalttransistoren (TS...) in Richtung des Signalflusses mindestens teilweise von Stufe zu Stufe nach einer geometrischen Reihe zu,
– ist das Kanalbreite-Kanallänge-Verhältnis (W/L-Verhältnis) des Anreicherungstransistors (TA) etwa gleich dem des Schalttransistors (TSA) des Ausgangsinverters (IA),
– ist zwischen dem Vorinverter (IV) und dem Ausgangsinverter (IA) ein Zwischeninverter (IZ) derart eingefügt, dass das Gate von dessen Schalttransistor (TSZ), der vom Anreicherungstyp ist, an den Gates der anderen Schalttransistoren (TSV, TSA) und das Gate von dessen Lasttransistor (TLZ), der vom Verarmungstyp ist, am Ausgang des Vorinverters (IV) liegt und die Gates des Anreicherungstransistors (TA)

und des Lasttransistors (TLA) des Ausgangsinverters (IA) mit dem Ausgang des Zwischeninverters (IZ) verbunden sind,
– ist die Kanalbreite des Schalttransistors (TSZ) des Zwischeninverters (IZ) etwa um den Multiplikationsfaktor der geometrischen Reihe grösser als die des Schalttransistors (TSV) des Vorinverters (IV), und
– für den restlichen Kapazitätsverhältnis-Teil (C2)
– sind signalflussmässig in Reihe geschaltete Vorstufeninverter (I1...I4) vorgesehen, die auf kürzeste Verzögerungszeit durch Konstanthalten des Quotienten aus der Eingangskapazität des innerhalb der Reihe nachfolgenden Inverters und dem W/L-Verhältnis des Lasttransistors des Inverters bemessen sind und deren W/L-Verhältnis in Richtung des Signalflusses von Stufe zu Stufe nach einer geometrischen Reihe zunehmen,
– liegt vor dem Eingang der Treiberstufe ein vom einen Teil (F2) des Zweiphasen-Taktsignals gesteuerter erster Transfertransistor (TT1), und
– liegt zwischen dem Ausgang des letzten Vorstufeninverters (I4) und dem Eingang der Ausgangsstufe ein vom anderen Teil (F1) des Zweiphasen-Taktsignals gesteuerter zweiter Transfertransistor (TT2).

2. MOS-Treiberschaltung nach Anspruch 1, dadurch gekennzeichnet, dass vom Eingang des zweiten Transfertransistors (TT2) ein Kondensator (CC) zum Schaltungsnullpunkt führt.

3. MOS-Treiberschaltung nach Anspruch 1 oder 2, dadurch gekennzeichnet, dass das W/L-Verhältnis des Lasttransistors (TLA) des Ausgangsinverters (IA) so bemessen ist, dass darin etwa die Hälfte der Gesamtstromaufnahme der Treiberschaltung fliesst.

**Claims**

1. Fast, with the aid of insulated-gate field-effect transistors monolithically integrated driver circuit for digital signals, which is connected between a load capacitance (CL) and the output of a stage (S; IM) which is capable of being loaded only with the comparatively small input capacitance (CV; CI) of the driver circuit and, for the purpose of realizing the capacitance ratio of the load capacitance to the input capacitance (C = CL/CV or CL/CI), contains inverters, namely, an output inverter (IA) and a pre-inverter (IV) which, in terms of signal flow, are connected in series, with an enhancement transistor (TA) being provided which, with its source-drain line, is connected in parallel with that of the load transistor (TLA) of the output inverter (IA), with the gate thereof, together with the gates of the load transistors (TLV, TLA) of the inverters (IV, IA), being connected to the output of the pre-inverter (IV), and with the gates of the switching transistors (TSV, TSA) of the inverters (IV, IA) being connected to one another, and with the load transistors (TLA, TLV) of the inverters (IA, IV) being of the depletion type, and the associated switching transistors (TSA, TSV) being of the enhancement type, characterized by the following features relating to capacitance ratios (C) greater than approximately 15 to 30 when realized in accordance with the twophase ratio technique:
- for a capacitance ratio part (C1) of about 15 to 30, with C = C1 · C2 being applicable,
  - the channel widths of the switching transistors (TS...) increase in the direction of the signal flow at least partially from stage to stage in accordance with a geometric progression,
  - the channel-width to channel-length ratio (W/L ratio) of the enhancement transistor (TA) is almost the same as that of the switching transistor (TSA) of the output inverter (IA),
  - an intermediate inverter (IZ) is inserted in such a way between the pre-inverter (IV) and the output inverter (IA) that the gate of its enhancement-type switching transistor (TSZ) is connected to the gates of the other switching transistors (TSV, TSA), and that the gate of its depletiontype load transistor (TLZ) is connected to the output of the pre-inverter (IV), while the gates of both the enhancement transistor (TA) and the load transistor (TLA) of the output inverter (IA) are connected to the output of the intermediate inverter (IZ),
  - the channel width of the switching transistor (TSZ) of the intermediate inverter (IZ) is larger by about the multiplication factor of the geometric progression than that of the switching transistor (TSV) of the pre-inverter (IV), and
- for the remaining capacitance ratio part (C2),
  - there are provided prestage inverters (I1...I4) which, in terms of signal flow, are connected in series, with them being dimensioned to the shortest delay time by keeping constant the quotient of both the input capacitance of the inverter subsequently following within the series and the W/L ratio of the load transistor of the inverter, and with the W/L ratios thereof increasing in the direction of the signal flow from stage to stage in accordance with a geometric progression,
  - ahead of the input of the driver stage there is disposed a first transfer transistor (TT1) which is controlled by one part (F2) of the two-phase clock signal, and
  - between the output of the last prestage inverter (I4) and the input of the output stage there is disposed a second transfer transistor (TT2) which is controlled by the respective other part of the two-phase clock signal.

2. A MOS driver circuit as claimed in claim 1, characterized in that from the input of the second transfer transistor (TT2) a capacitor (CC) leads to the zero point of the circuit.

3. A MOS driver circuit as claimed in claim 1 or claim 2, characterized in that the W/L ratio of the load transistor (TLA) of said output inverter (IA) is so dimensioned that almost half of the total current consumption of the driver circuit flows therein.

### Revendications

1. Circuit de commande rapide intégré monolithique à transistors à effet de champ à grille isolée, pour signaux numériques, qui est monté entre une capacité de charge (CL) et la sortie d'un étage (S; IM) ne pouvant être chargé que par la capacité d'entrée (CV; CI) relativement petite du circuit de commande, et qui, pour réaliser le rapport de capacités de la capacité de sortie sur la capacité d'entrée (C = CL/CV ou CL/CI), comporte des inverseurs montés en série du point de vue du flux de signaux, à savoir un inverseur de sortie (IA) et un inverseur préliminaire (IV), un transistor à enrichissement (TA) étant connecté, par son trajet source/drain, en parallèle avec celui du transistor de charge (TLA) de l'inverseur de sortie (IA) et ayant sa grille de commande connectée, ainsi que celle des transistors de charge (TLV, TLA) des inverseurs (IV, IA), à la sortie de l'inverseur préliminaire (IV), et les grilles de commande des transistors de commutation (TSV, TSA) des inverseurs (IV, IA) étant mutuellement reliées, les transistors de charge (TLA, TLV) des inverseurs (IA, IV) étant du type à appauvrissement et les transistors de commutation correspondants (TSA, TSV) étant du type à enrichissement, caractérisé par les caractéristiques suivantes pour des rapports de capacités (C) plus grands qu'environ 15 à 30 dans le cas d'une réalisation en technique de ratio biphasée:
- pour une partie (C1) du rapport de capacités de l'ordre de 15 à 30, C étant égal à C1 · C2,
  - les largeurs de canal des transistors de commutation (TS...) croissent, dans la direction du flux de signaux, au moins partiellement d'étage à étage, selon une progression géométrique,
  - le rapport largeur de canal sur la longueur de canal (rapport W/L) du transistor à enrichissement (TA) est à peut près égal à celui du transistor de commutation (TSA) de l'inverseur de sortie (IA),
  - un inverseur intermédiaire (IZ) est inséré entre l'inverseur préliminaire (IV) et l'inverseur de sortie (IA), de manière que la grille de commande de son transistor de commutation (TSZ), lequel est du type à enrichissement, soit reliée aux grilles de commande des autres transistors de commutation (TSV, TSA) et que la grille de commande de son transistor de charge (TLZ), lequel est du type à appauvrissement, soit reliée à la sortie de l'inverseur préliminaire (IV), les grilles de commande du transistor à enrichissement (TA) et du transistor de charge (TLA) de l'inverseur de sortie (IA) étant reliées à la sortie de l'inverseur intermédiaire (IZ),
  - la largeur de canal du transistor de commutation (TSZ) de l'inverseur intermédiaire (IZ) est, du facteur de multiplication de la progression géométrique, plus grande que la largeur de canal du transistor de commutation (TSV) de l'inverseur préliminaire (IV), et
- pour la partie restante (C2) du rapport de capacités,
  - il est prévu, montés en série du point de vue du flux de signaux, des inverseurs d'étages préliminaires (I1...I4) qui sont dimensionnés pour le temps de retard minimal par maintien à valeur constante du quotient de la capacité d'entrée de l'inverseur suivant au sein de la série par le rapport W/L du transistor de charge de l'inverseur, et dont les rapports W/L croissent, dans la direction du flux de signaux, d'étage à étage, selon une progression géométrique,
– un premier transistor de transfert (TT1) commandé par une partie (F2) du signal d'horloge biphasé se trouve avant l'entrée de l'étage-pilote, et
– un deuxième transistor de transfert (TT2), commandé par l'autre partie (F1) du signal d'horloge biphasé, se trouve entre la sortie du dernier inverseur d'étage préliminaire (I4) et l'entrée de l'étage de sortie.

2. Circuit de commande MOS selon la revendication 1, caractérisé en ce qu'un condensateur (CC) va de l'entrée du deuxième transistor de transfert (TT2) au point zéro du circuit.

3. Circuit pilote MOS selon la revendication 1 ou 2, caractérisé en ce que le rapport W/L du transistor de charge (TLA) de l'inverseur de sortie (IA) est dimensionné de manière telle qu'environ la moitié du courant total consommé par le circuit de commande s'y écoule.

Fig. 1

Fig. 4

Fig. 2

Fig. 3

Fig. 5